# EUROPEAN PATENT APPLICATION

(11) **EP 1 593 755 A1**
(43) Date of publication of application: **09.11.2005**
(21) Application number: 05000822.6
(22) Date of filing: 17.01.2005
(51) Int. Cl.: C23C 16/455

(54) **Film forming apparatus and method**

(30) Priority: 06.05.2004 JP 2004137237
(71) Applicant: Renesas Technology Corp., Tokyo 100-6334 (JP)
(72) Inventor: Kawahara, Takaaki, Tsukuba-shi Ibaraki 305-0053 (JP); Torii, Kazuyoshi, Tsukuba-shi Ibaraki 305-0053 (JP)
(74) Representative: HOFFMANN EITLE

(57) **Abstract**

An atomic layer deposition (ALD) apparatus capable of forming a conformal ultrathin-film layer with enhanced step coverage is disclosed. The apparatus includes an ALD reactor (101) supporting therein a wafer (102), and a main pipe (105) coupled thereto for constant supply of a carrier gas. This pipe (105) has two parallel branch pipes (105a-105b). Raw material sources (106a-106c) are connected by three-way valves (108a-108c) to one branch pipe (105a) through separate pipes (107a-107c), respectively. Similarly, oxidant/reducer sources (109a-109c) are coupled by three-way valves (111a-111c) to the other branch pipe (105b) via independent pipes (110a-110c). ALD works by introducing one reactant gas at a time into the reactor (101) while being combined with the carrier gas. The gas is "chemisorped" onto the wafer surface, creating a monolayer deposited. During the supply of a presently selected material gas from its source (106a) to a corresponding branch pipe (105a), this gas passes through its own pipe (107a) independently of the others. An ALD method is also disclosed.

## Description

### TECHNICAL FIELD

The present invention relates generally to a film-forming apparatus adaptable for use in the manufacture of semiconductor devices or else. More particularly but not exclusively, this invention relates to a film formation apparatus of the type relying upon atomic layer deposition (ALD) technology and having an improved raw material supplying system. The invention also relates to a method of forming a thin-film layer by using the apparatus.

### BACKGROUND OF THE INVENTION

One of important issues for the scaling of complementary metal oxide semiconductor (CMOS) devices in near future is to improve transistor characteristics while at the same time thinning gate insulating dielectric films. According to the update version of an article titled "International Technology Roadmap for Semiconductors (ITRS) 2002," 65-nanometer (nm) technology node generation devices with mass production expected to begin in 2005 are required to accomplish 1.2 to 1.6 nm in equivalent oxide thickness (EOT) of silicon dioxides (SiO₂). Unfortunately, it seems likely that conventionally used SiO₂ films are hardly employable for such advanced devices of this generation or later. This can be said because a gate leakage current occurring due to tunnel effects goes beyond an acceptable limit value. Thus, a need is felt to use another kind of material for gate insulator films in future devices. As the electrostatic capacitance of dielectrics is in proportion to the relative dielectric constant divided by a physical film thickness, the use of high-dielectric constant (K) materials including metal oxides permits the physical film thickness to increase, thereby enabling suppression of tunnel leakage currents. In particular, a composite film with a mixture of HfAlOₓ and HfSiOₓ or the like must be a promising one in viewpoints of both the resistivity and the high-temperature properties. Although such the high-K materials (metal oxides) may be formed by any one of atomic layer deposition (ALD), chemical vapor deposition (CVD) and sputtering methods, the ALD method would be preferable. This is because the ALD method is capable of growing a thin-film layer that is noticeably uniform in thickness and composition by taking full advantage of the chemical absorption or "chemisorption" while offering the easiness in material designs at the level of an atomic layer.

When a film is formed by the ALD method or a metal-organic CVD (MOCVD) method, one or more film-forming raw materials is/are used together with more than one oxidant or reducer (referred to as film formation aiding/assisting agent or "assistant" hereinafter). The raw materials may typically include precursor chemicals of hafnium (Hf), aluminum (Al) and silicon (Si). Examples of the Hf raw material are tetrakis(ethylmethylamino)hafnium (Hf(NEtMe)₄) abbreviated as "TEMAHf", HfCl₄, tetrakis(1-methoxy-2-methyl-2-propoxy) hafnium (Hf(MMP)₄:Hf(OC(CH₃)₂CH₂OCH₃)₄), tetra-tert-butoxy-hafnium (Hf(O-t-Bu)₄:Hf(OC(CH₃)₃)₄), tetrakis-dimethylamino-hafnium (Hf[N(CH₃)₂]₄) known as "TDMAH," tetrakis-diethylamino-hafnium (Hf [N (C₂H₅)₂]₄) called "TDEAH," hafnium-nitrate (Hf(NO₃)₄), and tetrakis-dipivaloylmethanato-hafnium (Hf(DPM)₄:Hf(C₁₁H₁₉O₂)₄). A typical example of the Al raw material is trimethylaluminum (Al(CH₃)₃) known as "TMA." Example of the Si raw material are tetrakis(ethylmethylamino)silicon (Si(NEtMe)₄) called "TEMASi," tetra-tert-butoxysilicon (Si(OC(CH₃)₃)₄) or Si(O-t-Bu)₄, tetraethoxysilane (Si(OC₂H₅)₄), also known as tetraethylorthosilicate ("TEOS"), and diethylsilane ((C₂H₅)₂SiH₂).
Regarding the film formation assistants, examples of the oxidant may be water (H₂O), oxygen (O₂) and ozone (O₃). Examples of the reducer are ammonia (NH₃) and hydrogen (H₂).

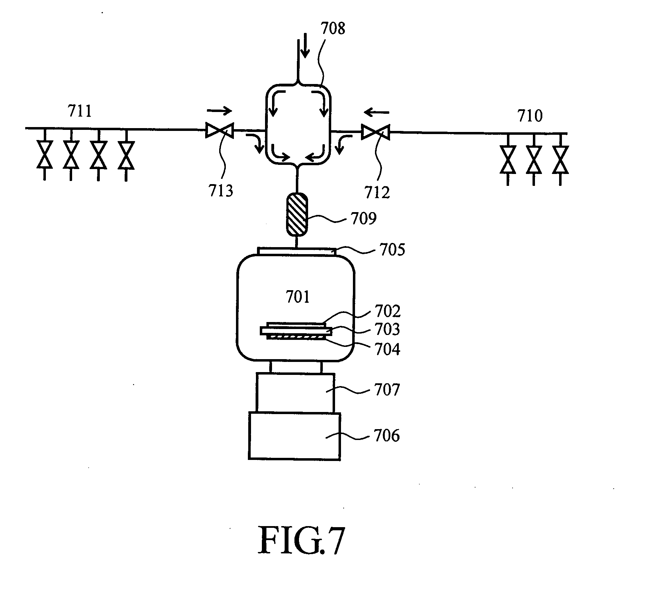

For instance, when forming an HfO₂ film by ALD method, use equipment structured as shown in Fig. 7. The procedure starts with the step of opening a manifold 710 for selection of a first film-forming raw material, thereby causing a selected raw material of HfCl₄ (solid at room temperature) to be supplied from an inlet valve 712 to one branch pipe of two-divided main carrier gas supply pipe 708, called a mixing manifold. Once introduced into an ALD reactor 701, the gas is chemically absorbed or "chemisorped" onto the surface of a wafer 702 being presently mounted in ALD reactor 701, thus forming a monolayer of molecules. Thereafter, the supply of HfCl₄ is interrupted. Then, purge HfCl₄. Next, open an inlet valve 713 of another manifold 711 for selection of a film-forming assistant, thereby supplying water (H₂O) for use as the assistant from the valve 713 to the other branch pipe of the main carrier gas pipe 708. After having decomposed and oxidized the HfCl₄ as has been absorbed onto the wafer 702, the supply of H₂O is halted, followed by purging of H₂O. With these four steps as a one cycle, a number of cycles of processing are repeated while controlling the cycle number. Thus, an HfO₂ film is formed at a rate of about 0.6 angstroms (Å) per cycle (i.e., 0.06 nm/cycle).

In case an AlN film is formed by ALD method, the apparatus of Fig. 7 is also used. Assuming that TMA is chosen as one of the film-forming raw materials, supply a TMA gas from the inlet valve 712 to one branch flowpath of the bisected main carrier gas supply pipe 708, thereby forming a chemisorped unimolecular layer on the wafer 702 situated within the ALD reactor 701. Thereafter, halt the supply of TMA, which is then purged. Next, supply a reducer of ammonia (NH₃), which is one of the assistant agents, from the valve 713 to the other bunch pipe of the main carrier gas pipe 708. During supplying of this NH₃ reducer, activate a remote plasma generator 709 to create a plasma of NH₃. Use this plasma to decompose and nitride the absorbed TMA on wafer 702. Thereafter, stop the NH₃ supply and the remote plasma generation. Then, purge NH₃. With these four steps as a one cycle, a number of cycles are repeated under control to thereby form the intended AlN film.

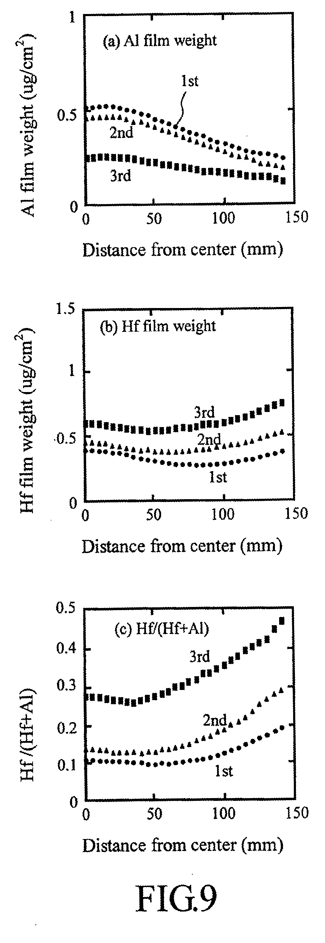

The inventors as named herein have studied the above-noted prior art to reveal the fact which follows. In case the prior known system shown in Fig. 7 is used to form a mixture layer of more than two kinds of metal oxide films such as for example HfAlOₓ and HfSiOₓ films, two or more kinds of film-forming raw materials must pass through the same line spanning from the raw-material selection manifold 710 to the valve 712, although not exactly at the same time. An example is that when this system is used to form an HfAlOₓ film by use of raw materials of TMA and TEMAHf along with an oxidant of H₂O, the film thickness is controlled by varying the cycle number, where one cycle consists of the steps of TMA pulsing (for 0.3 seconds), purging (1.3 sec.), H₂O pulse (0.4 sec.), purge (3 sec), TMA pulse (0.3 sec), purge (1.3 sec), H₂O pulse (0.4 sec), purge (3 sec), TEMAHf pulse (1.5 sec), purge (2.5 sec), H₂O pulse (0.8 sec), and purge (3 sec) in this order of sequence. Note that each number bracketed above is a time taken to execute corresponding processing. One cycle is 17.8 seconds in total time. Letting the cycle number be fifteen (15), three HfAlOₓ films were formed in succession. Each film has its Al adhesion amount, Hf adhesion amount and Hf/(Hf+Al) ratio, which have in-plane distribution patterns on the wafer surface along a radial direction as graphically shown in Figs. 9A to 9C, respectively. These graphs of Figs. 9A-9C plot the results of componential analysis along twenty nine (29) measurement points in the wafer radial direction. As apparent from Figs. 9A-9C, this prior art method suffers from problems which follow: the resultant film layer is inferior in uniformities of the in-plane deposit amount and composition ratio, and also less in stability. Although the initially formed film exhibits a relatively good Hf/(Hf+Al) ratio, even its (Vmax-Vmin)/Va/2 value is as large as plus/minus (±) 40 percent (%), where the Vmax is the maximum value, Vmin is the minimum value, and Va is the average value. It is considered that this is because TMA components residing between the selection manifold 710 and valve 712 react with TEMAHf in the pipe during the pulsing of TEMAHf.

Further, since the branched main carrier gas flows meet together prior to introduction into the remote plasma generator 709, all of the film-forming raw materials and assistants (oxidants and reducers) must pass through the same line extending from such the confluence part to the remote plasma generator 709. Hence, when a raw material gas passes through this part, it decomposes due to reaction with a different kind of raw material gas or oxidant or reducer residing in the pipe. The decomposition badly behaves to change the quality of a desired film on the wafer in some cases or create a large number of particles in other cases.

Another disadvantage of the prior art is as follows. If a raw material is kept stored in part of the pipeline system covering from a reservoir up to the selection manifold 710 and valve 712 during interruption of the film forming process, then the stocked raw material can experience condensation or solidification depending on the kind of such raw material. This causes baneful influences, such as pipe blockage, unwanted particle creation and others.

A further disadvantage faced with the prior art is as follows. In case the ALD reactor 701's upper part (chamber lid) is opened to perform chamber cleaning or else, it is a must to unlock joints that are provided at the raw material and oxidant/reducer supply lines being rigidly coupled to the ALD reactor upper face in order to establish releasabilities whenever the chamber lid is opened and closed. Frequent execution of joint lock/unlock operations upon opening and closing of the chamber lid would cause accidental gas leakage at such portions.
The above-noted ALD equipment is disclosed in USP No. 6,503,330 to Ofer Sneh et al. Reference is also made to an article titled "APPARATUS AND METHOD TO ACHIEVE CONTINUOUS INTERFACE AND ULTRATHIN FILM DURING ATOMIC LAYER DEPOSITION," by Ofer Sneh et al. from Genus, Inc., Sunnyvale, CA (US).

### SUMMARY OF THE INVENTION

This invention has been made in order to solve the above-noted problems faced with the ALD film formation apparatus and method using a plurality of film-forming raw materials, and its object is to provide an improved film formation method and apparatus capable of ameliorating the in-plane uniformity of an ALD film thus formed.

In accordance with one aspect of the invention, a film forming apparatus includes an atomic layer deposition (ALD) reactor which supports therein a wafer or substrate to be processed, a main carrier gas supply pipe for constantly supplying a carrier gas to the ALD reactor, a plurality of film-forming raw material supply sources, a raw material supply pipe coupled to the main pipe via a valve for directly supplying to the main pipe a raw material being fed from the raw material supply sources, an assistant supply source for supplying a film-forming assistant agent including an oxidant or a reducer, and an assistant supply pipe coupled to the main pipe through a valve for directly supplying the assistant as fed from the assistant supply source. The main carrier gas supply pipe is divided into two branch pipes, one of which is for enabling the direct supply of different kinds of film-forming raw materials via separate three-way valves respectively while preventing these raw materials from passing through the same pipe at a time. The other branch pipe of the main pipe permits the direct supply of different kinds of film-forming assistants via separate three-way valves respectively while preventing the materials from flowing in the same pipe.

In accordance with another aspect of the invention, there is provided a film forming method using film deposition equipment at least having an ALD reactor for supporting therein a substrate to be processed, a main carrier gas supply pipe for constantly supplying a carrier gas to the ALD reactor, a plurality of film-forming raw material supply sources, a raw material supply pipe coupled to the main pipe via a valve for directly supplying to the main pipe a film-forming raw material being fed from the film-forming raw material sources, more than one assistant supply source for supplying a film-forming assistant agent including an oxidant or a reducer, and an assistant supply pipe coupled to the main pipe through a valve for directly supplying the assistant as fed from the assistant source. The method includes absorbing the film-forming raw material and the assistant on the substrate to be processed as disposed within the ALD reactor, forming thereafter a chemically absorbed or "chemisorped" film, and then repeating these steps a plurality of times to thereby form a thin film. When sequentially supplying the plurality of film-forming raw materials and assistants to the ALD reactor, different kinds of raw materials and assistants are sent with the aid of a carrier gas or gases to the ALD reactor by way of different raw material/assistant supply pipes, without using a common raw material supply pipe and a common assistant supply pipe.

### BRIEF DESCRIPTION OF THE DRAWINGS

Fig. 1 is a diagram schematically showing a film formation apparatus using an ALD raw material supply system in accordance with a first embodiment of the present invention.

Fig. 2 is a diagram pictorially depicting part of a film-forming assistant supply unit of the ALD raw material supply system of the first embodiment of this invention.

Fig. 3 is a diagram schematically illustrating a film formation apparatus using an ALD raw material supply system in accordance with a second embodiment of the invention.

Fig. 4 is a diagram schematically showing a film formation apparatus in accordance with a modified example of the second embodiment of the invention.

Fig. 5 is a diagram schematically showing a film formation apparatus using an ALD raw material supply system in accordance with a third embodiment of the invention.

Fig. 6 is a schematic diagram of a film formation apparatus using an ALD raw material supply system in accordance with a fourth embodiment of the invention.

Fig. 7 schematically illustrates a prior known film formation apparatus using an ALD raw material supply system having two-divided main carrier gas pipes.

Figs. 8A to 8C are graphs each showing the in-plane uniformity of a thin film for demonstration of the ultimate efficacy of the embodiment of the invention.

Figs. 9A-9C are graphs each showing the in-plane uniformity of a thin film in the case of employing a prior art ALD film-forming method.

### DETAILED DESCRIPTION OF THE INVENTION

Thin-film materials suitable for use in the present invention include, but not limited to, oxides and oxynitrides containing therein a plurality of kinds of metal elements. Typical examples thereof are HfAlOₓ, HfSiOₓ, HfSiONₓ and equivalents thereto. An exemplary approach to forming such thin film is to use a plurality of raw materials such as the above-noted TEMAHf and TMA or the like along with more than one film-forming assistant chemical, which may be an oxidizing agent such as water or a reducing agent such as an ammonia gas.
In this invention, the film-forming raw materials are as follows. Currently preferred examples of the Hf raw material are tetrakis(ethylmethylamino)hafnium (Hf(NEtMe)₄) abbreviated as "TEMAHf", HfCl₄, tetrakis(1-methoxy-2-methyl-2-propoxy) hafnium (Hf(MMP)₄:Hf(OC(CH₃)₂CH₂OCH₃)₄), tetra-tert-butoxy-hafnium (Hf(O-t-Bu)₄:Hf(OC(CH₃)₃)₄), tetrakis-dimethylamino-hafnium (TDMAH:Hf[N(CH₃)₂]₄), tetrakis-diethylamino-hafnium (TDEAH:Hf[N(C₂H₅)₂]₄), hafniumnitrate Hf(NO₃)₄, and tetrakis-dipivaloylmethanato-hafnium (Hf(DPM)₄:Hf(C₁₁H₁₉O₂)₄). An example of the Al raw material is trimethylaluminum (Al(CH₃)₃), known as "TMA." Examples of the Si raw material are tetrakis(ethylmethylamino)silicon (Si(NEtMe)₄), called "TEMASi," Si(O-t-Bu)₄[tetra-tert-butoxysilicon:Si(OC(CH₃)₃)₄], tetraethoxysilane (Si(OC₂H₅)₄) known as "TEOS", and diethylsilane ((C₂H₅)₂SiH₂).
The film-forming assistant agent as used herein may be water (H₂O), oxygen (O₂) or ozone (O₃) for use as the oxidant, or alternatively, ammonia (NH₃) or hydrogen (H₂) or else for use as the reducer. The carrier gas is typically an inert gas, such as argon or nitrogen.

### FIRST EMBODIMENT

### Film Forming Apparatus

A first embodiment of the present invention will now be explained below. This embodiment is arranged so that a main carrier gas supplying pipe is split or "branched" to provide a couple of parallel gas flow paths. Directly coupled to these branched main carrier gas supply pipes―say, branch pipes―are those pipes which are extended from a plurality of film-forming raw material supply units or "sources" and film formation assistant supply sources. Using such pipe structure is aimed at preclusion of mutual contact of different kinds of raw materials and assistants prior to the introduction into the main carrier gas supply pipe.

More specifically, the film forming apparatus embodying the invention may be an atomic layer deposition (ALD) film formation equipment which includes a disperser, a susceptor, and a heat module. The disperser may be a shower plate. A main carrier gas is slit into two gas flows, which are guided to pass through the shower plate and also an ALD reactor, throttle valve, rough pump and others and are then exhausted. To one of the branch pipes of the main carrier gas supply pipe, any one of different kinds of film-forming raw materials is directly supplied in such a manner that it does not pass through the same pipe before arrival at the confluence with the main carrier gas. Regarding the other branch pipe of the main pipe, a chosen one of oxidants or reducers is capable of being directly supplied to the branch pipe without having to pass through the same pipe before its confluence with the main carrier gas. A respective one of the raw material and the assistant that is an oxidant or reducer is supplied to the main carrier gas supply pipe through a three-way valve and is then mixed or blended into a carrier gas for transportation. Furthermore, the branch pipes of the main carrier gas supply pipe with raw material and assistant gases being fed thereto are extended along separate routes without meeting together to reach the ALD reactor, thereby providing what is called the double injector structure.

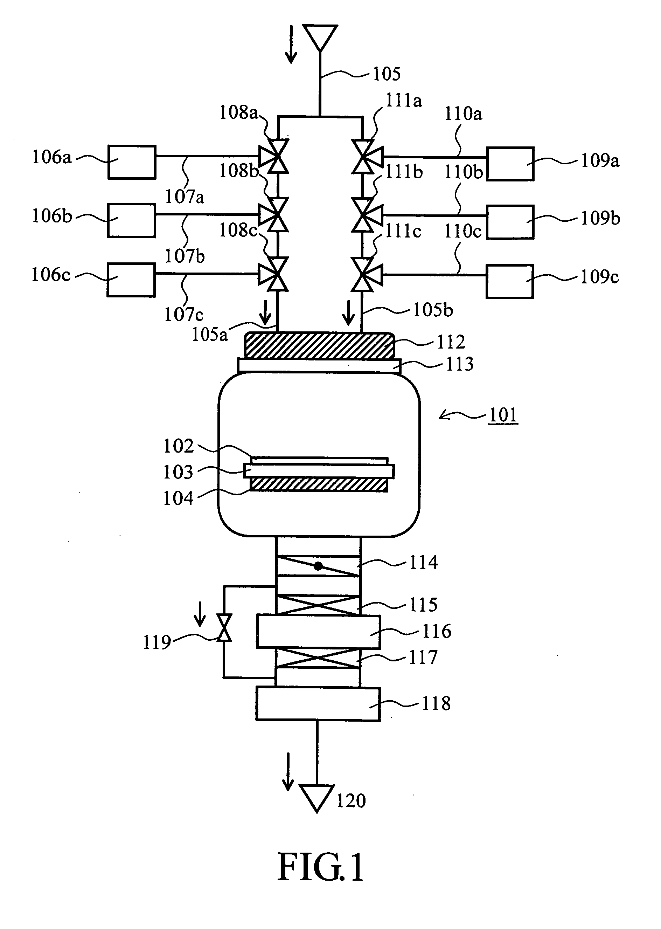

A detailed explanation will now be given of a film formation apparatus embodying the invention with reference to Fig. 1, which is a schematic cross-sectional view of the apparatus. This apparatus is ALD film forming equipment including a disperser or "shower" plate 113, ALD reactor 101, wafer 102, susceptor 103, and heater module 104. A main carrier gas introduced into a main pipe 105 is guided to pass through the shower plate 113 and ALD reactor 101 as well as a throttle valve 114, bypass valve 119 and rough pump 118 and is then exhausted as indicated by numeral 120.

Chosen raw materials for film formation, also called precursor chemicals, are supplied from raw material supply sources 106a, 106b and 106c. Each raw material is transported with the aid of a carrier gas so that it flows into the main carrier gas supply pipe by way of a raw material supplying pipe 107a, 107b, 107c and a three-way valve 108a, 108b, 108c. In addition, any one of the assistant agents (or reactive chemicals) for promoting film formation is delivered by a carrier gas from an assistant supply source 109a, 109b, 109c and is guided to pass through an assistant supply pipe 110a, 110b, 110c and its associated three-way valve 111a, 111b, 111c and then flow into the main carrier gas supply pipe. These are chemically absorbed or "chemisorped" respectively onto a top surface of a wafer 102 being presently disposed in the ALD reactor 101, and are thus used for the fabrication of an ultra-thin film layer of uniform and conformal coatings over high-aspect and uneven features present on the wafer.

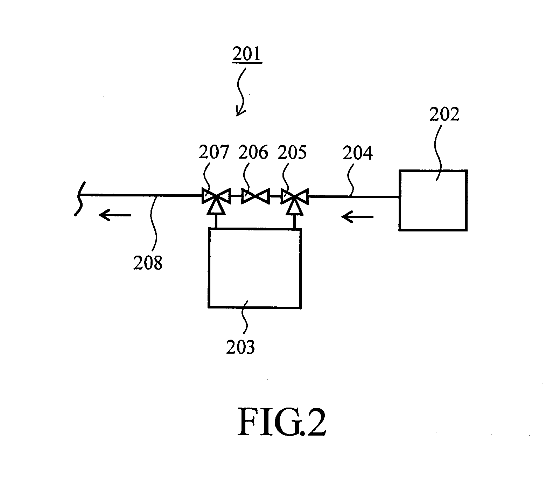

As shown in Fig. 2, the film-forming raw material supply sources 106a-106c and assistant supply sources 109a-109c are each arranged to have a raw material carrier gas reservoir 202, a raw material tank 203, a tank inlet valve (e.g., three-way valve) 205, a tank bypass valve 206, and a tank outlet valve (three-way valve) 207. Upon supplying of a raw material, the three-way valves 205 and 207 are driven to introduce a raw material carrier gas into the tank 203, for transporting the raw material while letting it be mixed or combined with the carrier gas. On the other hand, when interrupting the supply of the raw material, the three-way valves 205, 206 are driven to control the flow path of such carrier gas so that the raw material carrier gas flows in such a way as to bypass the raw material tank 203. It should be noted that this tank 203 is arranged so that its associated heater device is additionally provided to enable the raw material―this is in the form of a fluid or a solid in room temperature―to be heated up to a target temperature which provides a sufficiently high vapor pressure.

For example, the temperature is 167°C for HfCl₄; in this case, a vapor pressure of 0.1 Torr is obtained. As for TEMAHf, the temperature is 83°C. Every pipe residing along a route spanning from the film-forming raw material tank 203 and outlet valve 207 and leading to ALD reactor 101 is set at such the temperatures suitable for these raw materials (for example, at 167°C for HfCl₄ and 83°C for TEMAHf).

In the case of a gas that stays stable at room temperature such as oxygen (O₂), the film-forming raw material carrier gas reservoir 202 is designed to supply an O₂ gas, with the raw material tank 203 and tank inlet valve (three-way valve) 205 plus tank outlet valve (three-way valve) 207 being eliminated.

Turning back to Fig. 1, the main carrier gas supply pipe 105 is divided into two parallel branch pipes 105a and 105b, thereby providing the so-called double injector structure. One of these branch pipes, 105a, is provided with a plurality of three-way valves 108a-108c, whereas the other branch pipe 105b has three-way valves 111a-111c. With this design, the different kinds of film-forming raw materials (i.e., those being fed from the raw material sources 106a-106c) are directly supplied, one at a time, to the branch pipe 105a of main pipe 105 while preventing different raw material gases from passing through the same raw material supply pipe 107a, 107b, 107c prior to the confluence with the main carrier gas. Regarding the other main carrier gas branch pipe 105b, this is arranged so that different types of oxidants or reducers (i.e., film-forming assistants being fed from the assistant sources 109a-109c) are capable of being directly supplied, one at a time, to the branch pipe 105b. Since the main carrier gas is constantly flowing from the upstream of the main carrier gas supply pipe 105 to a remote plasma generating device 112 of Fig. 1, there is obtained the structure that permits smooth flow of the raw material gases and the oxidants or reducers without experiencing detentions or delays.

Note here that although in Fig. 1 the remote plasma generator device 112 is provided, this device may be omitted in a way depending upon thin-film materials and formation conditions thereof.

### Film Forming Method

A method of forming an ultrathin film using the ALD apparatus shown in Figs. 1-2 will be explained under an assumption that a film formed is a monolayer of HfAlOₓ, although the method is also implementable when applying to other kinds of thin-film materials. In the film fabrication of this embodiment, TMA and TEMAHf are employed for use as the film-forming raw materials or precursors. An oxidant as used herein is water. An argon gas is used as carrier gas.

Firstly, a main carrier gas is supplied to the main carrier gas supply pipe 105. Let this carrier gas flow constantly. The carrier gas may be arranged so that its flow rate or "throughout" ranges from 0.01 to 10 slm.

In this event, all the valves coupled to the main carrier gas supply pipe 105―i.e., the film-forming raw material supply valves 108a-108c and assistant supply valves 111a-111c―are closed. Then, the intended thin film will be formed in accordance with the process steps which follow.

### First TMA Absorption Step

The three-way valves 205, 207 are operated so that a chosen carrier gas is sent from the film-forming raw material carrier gas reservoir 202 into the raw material tank 203 of the raw material supply source 106a that contains therein TMA (it is not necessary to heat TMA because this material has a sufficient vapor pressure even at room temperature). Thus, the supply of the film-forming raw material gets started. Open the raw material supply valve 108a for 0.05 to 5 seconds, preferably 0.3 seconds, thereby delivering a carrier gas containing this raw material gas to the branch pipe 105a of main carrier gas supply pipe 105. Thereafter, close the valve 108a. This raw material-containing carrier gas flows in the branch pipe 105a and then passes through the shower head 113 to enter the ALD reactor 101. Next, this gas is absorbed or chemisorped onto the surface of a wafer 102 on the susceptor 103, which is disposed within the ALD reactor 101. In this process, the interior space of ALD reactor 101 is maintained at a pressure of 200 mTorr and a temperature of 300°C.

### First Purge Step

Next, close the film-forming raw material supply valves 108a-108c and assistant supply valves 111a-111c, resulting in none of the raw materials and assistants being supplied. Instead, only the carrier gas that is a chemically non-reactive gas is caused to flow in the main carrier gas supply pipe for 0.1 to 10 seconds―preferably, 1.3 sec. During the flow of this carrier gas, any residual TMA gas components within the pipe system are removed away.

### First H₂O Reaction Step

In a similar way to the first TMA absorption step, start supplying of a water vapor together with a carrier gas along a route spanning from the film-forming assistant supply source 109a through the assistant supply pipe 110a. Then, open its associated valve 111a for sending it to the branch pipe 105b of main pipe 105, preferably for 0.4 seconds. Thus a short burst of gas is supplied into the ALD reactor 101. Thereafter, close the valve 111a. The water thus fed to ALD reactor 101 is absorbed into the surface of wafer 102 and then reacts with a preabsorbed TMA.

### Second Purge Step

As in the first purge step stated supra, only the carrier gas is flown for 0.1 to 10 seconds―preferably, 3 seconds―to thereby purge unreacted materials toward the outside of the system.

### Second TMA Absorption Step

Subsequently, second TMA absorption is performed in a way similar to the first TMA absorption step stated previously.

### Third Purge Step

As in the first purge step stated supra, only the carrier gas is delivered for 0.1 to 10 seconds, preferably 1.25 seconds, to thereby purge unreacted materials to the outside of the system.

### Second H₂O Reaction Step

Subsequently, as in the aforesaid first H₂O reaction step, a water vapor is sent, together with its carrier gas, through the film-forming assistant supply pipes 110a for 0.05 to 5 seconds, preferably 0.4 sec., to the branch pipe 105b of main pipe 105. The water vapor is thus introduced into ALD reactor 101. Then, let it react with TMA that was preabsorbed on the wafer surface.

### Fourth Purge Step

As in the first purge step stated supra, only the carrier gas is flown for 0.1 to 10 seconds, preferably 3 sec., to thereby purge unreacted chemicals to the outside of the system.

### TEMAHf Absorption Step

The three-way valves 205 and 207 are driven so that a carrier gas is sent from the reservoir 202 to the tank 203 of the film-forming raw material source 106a that contains TEMAHf, which is preheated to an appropriate temperature that allows TEMAHf to have a sufficient vapor pressure. This results in startup of supplying the raw material. Then, open the valve 108b for 0.05 to 5 seconds, preferably 1.5 sec., to send the carrier gas containing this raw material toward the branched main pipe 105a. Thereafter, close valve 108b. This raw material-containing carrier gas passes through the branch pipe 105a and is then sent via the shower head 113 into the ALD reactor 101, followed by absorption or "chemisorption" onto the surface of wafer 102 being presently disposed in ALD reactor 101. In this event, ALD reactor 101 is retained at a pressure of 200 mTorr and at a temperature of 300°C.

### Fifth Purge Step

As in the first purge step stated supra, only the carrier gas is flown for 0.1 to 10 seconds, preferably 2.5 sec., to thereby purge unreacted materials to the outside of the system.

### Third H₂O Reaction Step

Subsequently, as in the first H₂O reaction step stated supra, a water vapor is sent, together with its carrier gas, through the pipe 110a for 0.05 to 5 seconds, preferably 0.8 sec., to the branched main pipe 105b, and then introduced into ALD reactor 101. Next, let it react with TMA that was preabsorbed in the wafer.

### Sixth Purge Step

As in the first purge step stated previously, only the carrier gas is flown for 0.1 to 10 seconds, preferably 2.5 sec., to thereby purge unreacted materials to the outside of the system.

The above-noted steps are repeated a number of times to form a thin film to a desired thickness. Thus it is possible to fabricate an ALD thin-film layer with excellent in-plane uniformity.

### SECOND EMBODIMENT

This embodiment is aimed at elimination of a need for supplying to the ALD reactor 101 those gases that are altered in quality due to continuous residence in flowpath lines. To this end, a ventilation tube (vent line) is further added to more than one pipe which supplies either a film-forming raw material or assistant to the main carrier gas supply pipe 105 and which extends up to a three-way valve associated therewith. By letting a carrier gas continuously flow in this ventilation pipe system, any gas residing in a raw material/assistant supply pipe may be exhausted without experiencing mixture with other gases while no film formation is being performed. This eliminates unwanted supplying of any quality-altered gas residing in the supply line to the ALD reactor.

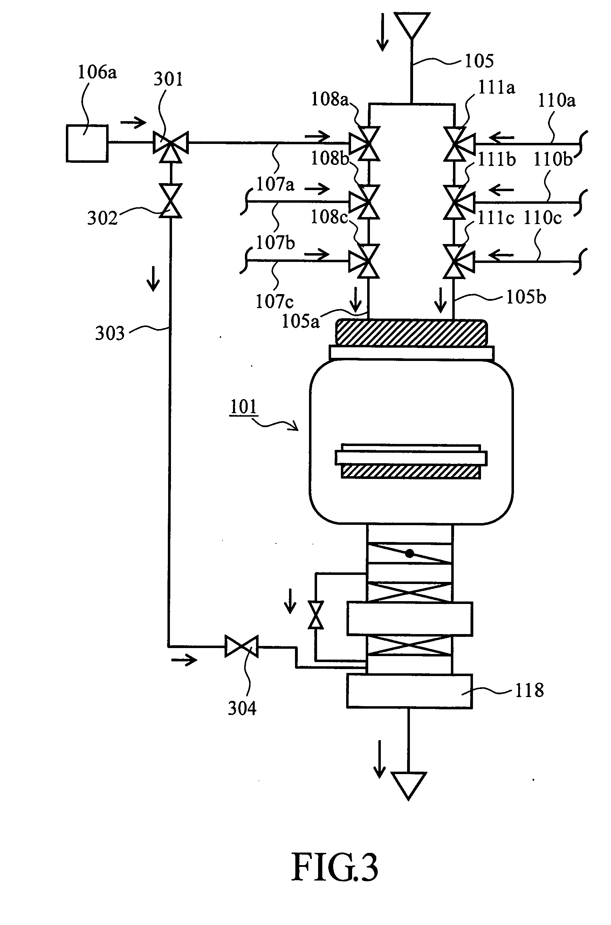

A film forming apparatus of this embodiment will be explained with reference to Fig. 3, which depicts its cross-sectional view. In Fig. 3, the members similar in function to those of the above-noted apparatus of the previous embodiment are denoted by like reference characters, and detailed explanations thereof will be eliminated herein. Note here that although in Fig. 3 the ventilation line added is illustrated in terms of only the pipe system extending from the film-forming raw material supply source 106a, it is desirable that similar mechanisms be added to the other raw material/assistant supply sources.

As shown in Fig. 3, the film formation apparatus of this embodiment is uniquely arranged to have a ventilation line, which includes a vent-use three-way valve 301 that is disposed at intermediate part of the film-forming raw material supply pipe 107a extended from the raw material supply source 106a. A raw material-containing gas is guided to pass through a vent pipe 303. This gas flows via a vent-side normally-open valve 302 and vent-side valve 304 and is then externally exhausted from a rough pump 118.

In this film formation apparatus, when the film-forming raw material being supplied for example from the raw material supply source 106a is used for film fabrication, the vent-use three-way valve 301 is driven to change the flow path so that the gas flows from source 106a to its associated valve 108a. At this time, the vent-side normally-open valve 302 and vent-side valve 304 are closed. On the other hand, when the raw material being fed from the supply source 106a is not used for the film fabrication, the vent-use three-way valve 301 is driven to switch the flowpath to thereby permit the flow of the carrier gas being constantly fed from the source 106a. Simultaneously, let the valves 302 and 304 open.

This valve operation is similarly applicable to those vent lines associated with any other raw material and assistant supply sources.

This embodiment is similar to the aforementioned first embodiment in that regarding a raw material inherently low in vapor pressure, the exhaust gas line also is heated to elevate its temperature in substantially the same way as that of the gas supply line. A bore diameter-increased or "fat" exhaust pipe is preferably employed to allow the gas to be efficiently exhausted without mixing with other gases. This is inevitable because if different kinds of raw material gases and oxidants or reducers flow together in a small-bore or "slender" exhaust pipe, then these can react with one another resulting in occurrence of the following risks: unwanted creation of particles within the pipe, and valve clogging accidents. Although the vent-use three-way valve 301 and vent-side valve 304 are omissible in use, it is preferable to install these valves 301 and 304 because if the vent-side normally-open valve 302 leaks then the intended film formation is no longer executable. Optionally the pump 118 that is in the downstream of the vent-side valve 304 may be replaced by an independently operable pump, which is separate from the rough pump 118 for use with ALD reactor 101.

The film forming apparatus of this embodiment ensures that a film-forming raw material or assistant which is uninvolved in a film formation step being carried out within a given time period of the film forming process is efficiently exhausted from the vent-use valve 303 with the aid of a carrier gas without being supplied to the system of main carrier gas supply pipe 105, which carrier gas constantly delivers the raw material or assistant. This in turn prevents accidental contact with the other raw material gases. Thus, the resulting film was improved in uniformities of in-plane film thickness and composition and also in reproducibility. Furthermore, the particle amount also was reduced. It is contemplated that in the prior art, unwanted particles are created due to the occurrence of gas alteration, condensation and/or solidification at bore-narrowed portions and low-temperature portions because of the fact that raw material gases of low vapor pressure stay in supply lines for a long time while the film fabrication is temporarily interrupted. In contrast, with the apparatus embodying the invention, it was possible to reduce or minimize the particle amount to thereby improve the stability of film fabrication, by performing the vent exhaust of any residual gas or gases in the supply lines during the interruption of film fabrication processing.

Regarding a film forming method using the embodiment apparatus shown in Fig. 3, this method is similar to that of the first embodiment discussed previously, except that the vent line 303 associated with any one of the film-forming raw material/assistant supply sources 106a-106c and 109a-c which is presently out of use for the film formation is manipulated to forcibly guide a carrier gas fed from the unused source so that it flows into the gas exhaust system.

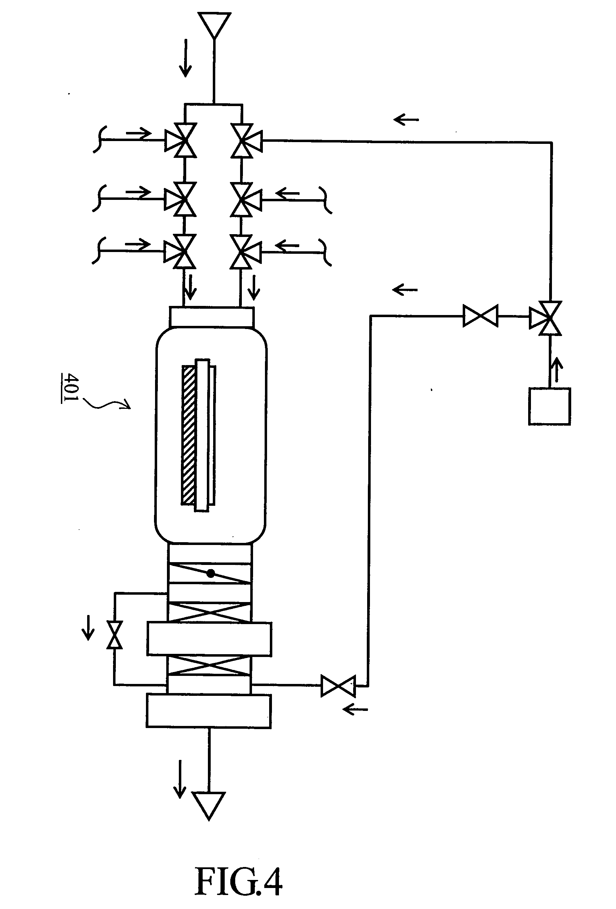

Additionally the above-noted vent line system of this embodiment is also applicable to an ALD reactor 401 of the laminar flow type such as shown in Fig. 4.

### THIRD EMBODIMENT

This embodiment is arranged so that the main carrier gas supply pipe 105 of Fig. 1 is divided into an increased number of parallel branch pipes, which number is equal to a total number of different kinds of film-forming raw materials and assistant chemicals used. Respective branch pipes are capable of supplying different raw materials and assistants through three-way valves as provided therein independently of one another. This multiple branch pipe system almost completely avoids the risk that more than two of the different raw materials and assistants (i.e. oxidants or reducers) must pass through an identical or common pipe system upon introduction into the ALD film forming reactor, thereby further improving the uniformity of a thin-film layer thus formed.

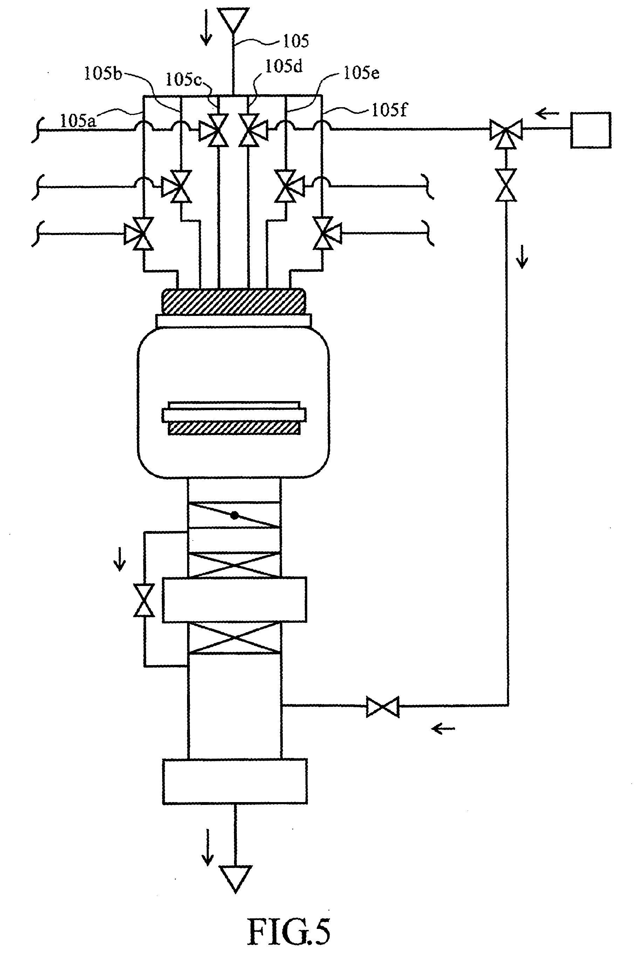

An explanation will be given of a film forming apparatus of this embodiment with reference to Fig. 5, which is a pictorial representation of the apparatus. In Fig. 5, the same parts or components as those in the apparatus of each of the above-noted embodiments are designated by the same numerals and symbols, with detailed explanations thereof eliminated herein.

As shown in Fig. 5, the film forming apparatus of this embodiment is designed to use a unique ALD precursor supplying system, which is arranged as follows. Suppose that film-forming raw materials and assistants used for the intended film formation are six kinds of chemical substances or precursors, for example. The main carrier gas supply pipe 105 is split into six parallel branch pipes 105a to 105f as shown in Fig. 5. This split number is equivalent to the total number of different kinds of chemical substances. Three adjacent ones of these branched main pipes 105a-105f have three-way valves 108a-108c, whereas the remaining three ones have three-way valves 111a-111c, respectively. The individual branch pipe is arranged so that a different kind of gas―i.e. a film-forming raw material or assistant gas―is supplied thereto from its associated raw material/assistant supply source.

With the "multiple branched main pipe" structure, it is possible to transport any one of the six different kinds of film-forming raw materials and assistants without letting them pass through the same line at a time until the introduction into the ALD film-forming reactor. More specifically, the purge time required can be shortened while improving the throughput about 1.5 times, when compared to the case where a film-forming raw material supply pipe is used in common for a plurality of chemical species such as TMA and TEMAHf as shown in Fig. 1. Another advantage is that scant mixture of AlOₓ becomes fully depleted, which mixture can occur when forming an HfO₂ film after having formed an Al₂O₃ film as an example.

In the embodiment apparatus shown in Fig. 5, a specific example is shown which is provided with a vent line that is arranged so that a vent-use three-way valve 301, vent-side normally-open valve 302, vent-side valve 304 and vent pipe 303 are disposed at an intermediate part of the pipe 107a of a film-forming raw material being fed from the supply source 106a while causing a carrier gas being delivered from the raw material supply source to flow into the branched main carrier gas supply pipe 105a, although this vent line may be omitted when the need arises.

The film formation apparatus and method of this embodiment are such that any one of the multiple branched main pipes 105a-105f is dedicated for the exclusive flow of a single type of chemical specie. Thus, the risk of coexistence of different chemical substances is noticeably lowered. This makes it possible to shorten the purge time required.

### FOURTH EMBODIMENT

A film forming apparatus of this embodiment is arranged to have an ALD reactor that consists essentially of a main body and a lid structure, with a main carrier gas supply pipe being rigidly provided to the ALD reactor lid. The apparatus has film-forming raw material and assistant supply pipes that are designed to penetrate outer walls of the ALD reactor along the route spanning from their corresponding material sources up to the main carrier gas pipe while letting them be separatable between the ALD lid and ALD main body. With such the separatable pipe design, it is possible to simplify pipe attaching/detaching works at the time the ALD reactor lid is opened and closed.

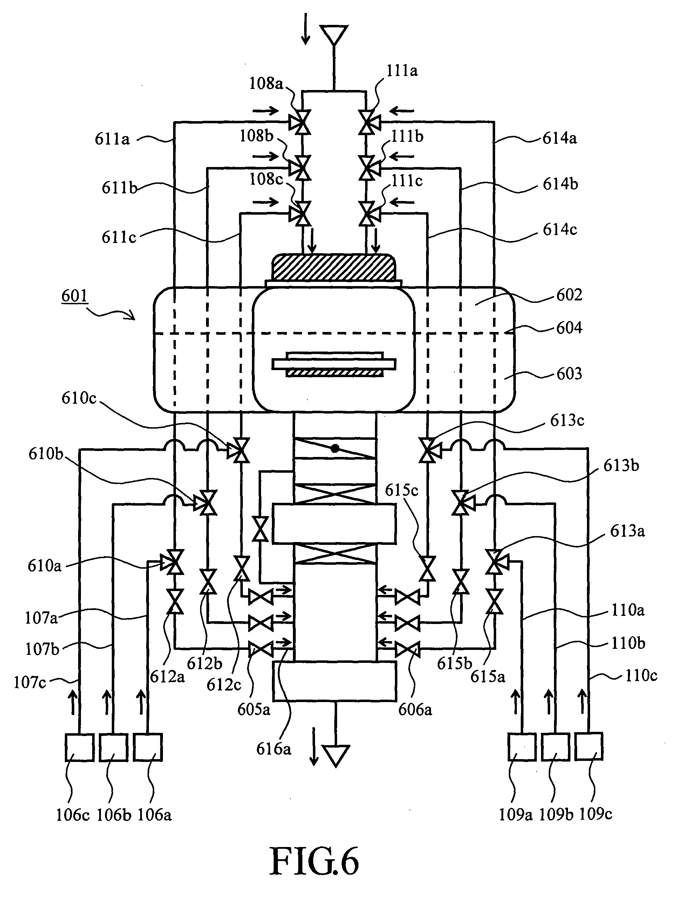

The film forming apparatus of this embodiment will be explained using Fig. 6, which depicts its schematic cross-sectional view. In Fig. 6, the same parts or components as those in the apparatus of each of the previous embodiments are denoted by the same numerals, with detailed explanations thereof omitted herein.
As shown in Fig. 6, the apparatus includes an ALD reactor 601, which is horizontally divided into two parts in a plane 604. Thus the ALD reactor 601 is made up of a cover or lid structure 602 and a main body housing 603. ALD reactor 601 has its outer walls including two opposite, top and bottom walls. Film-forming raw material pipes 611a-611c, and assistant supply pipes 614a-614c are buried to penetrate the top and bottom outer walls of ALD reactor 601. Very importantly, these pipes 611a-c and 614a-c are designed so that each is separatable into two pipe segments at the split plane 604 of ALD reactor 601.

The pipes 611a-611c and 614a-614c that vertically penetrate the outer top wall of ALD reactor lid 602 and the outer bottom walls of reactor housing 603 are air-tightly sealed by O-rings at their joints, thereby avoiding a need for troublesome locking-and-unlocking operations of the joint of each line at the time the ALD reactor lid 602 is opened and closed. Note that in the case of the chamber structure shown in Fig. 3 which does not require the opening and closing of the ALD reactor lid (upper part) since this operation is replaced by an operation of lowering the chamber bottom face, or alternatively in the case of the laminar-flow type ALD reactor 401 of Fig. 4, the arrangement above is unnecessary because the open/close operations of each line are not particularly present.

Fig. 6 shows a film formation apparatus also embodying the invention. This apparatus is designed so that those portions of the lines 611a-611c and 614a-614c for supplying film-forming raw materials and assistants to be fed to the main carrier gas line, which portions extend up to three-way valves 610a-610c and 613a-613c, penetrate the outer wall 603 of ALD reactor 601. Note here that upon opening and closing of the ALD reactor cover (upper lid) 602, it is no longer required to open and close the raw material/assistant supply lines such as by providing joints or the like.

Avoiding the need for the open/close operations of each line joint makes it possible to preclude accidents such as the leakage of a dangerous gas such as TMA otherwise occurring due to the deficiency of joint fastening or locking to be done after every open/close event. It is also possible to shorten a time taken for leak check of each line joint. This is devoted to reduction of a system shut-down time. It is also possible to reduce in number those parts using consumables, such as joint gaskets or else.

In the embodiment apparatus of Fig. 6 a specific example is shown which is provided with a ventilation line 611a that is designed so that a ventilating three-way valve 610a, vent-side normally-open valve 612a, vent-side valve 605a and vent-use pipe 616a are disposed at a midway portion of the pipe 107a that supplies a film-forming raw material being fed from the supply source 107a while causing a carrier gas being delivered from the source to flow into the main carrier gas exhaust system, although this vent line may be omitted. Similar vent lines 611b-611c and 614a-614c are associated with the remaining raw-material/assistant supply pipes 107b-107c and 110a-110c, respectively, as shown in Fig. 6.

### Modification and Usage

While the film forming apparatus and method incorporating the principles of this invention are adaptable for use in the manufacture of semiconductor integrated circuit (IC) devices including logic circuits and memory chips such as dynamic random access memories (DRAMs), the invention are also applicable to the fabrication of other types of microelectronics devices including, but not limited to, ultrathin-film magnetic head modules, organic light emitting diode (LED)-based micro image display elements, magnetic RAMs (MRAMs), photoelectric devices, micro-electromechanical systems (MEMSs), devices for use in ink-jet printers, and microstructural capacitors, in the light of the advantageous features unique to the invention, such as the capability for fabricating physically strong or "robust" device structures, an ability to form highly controllable and reproducible thin films on the order of angstroms, and an ability to form ultrathin-film layers having excellent electrical properties.

### Examples

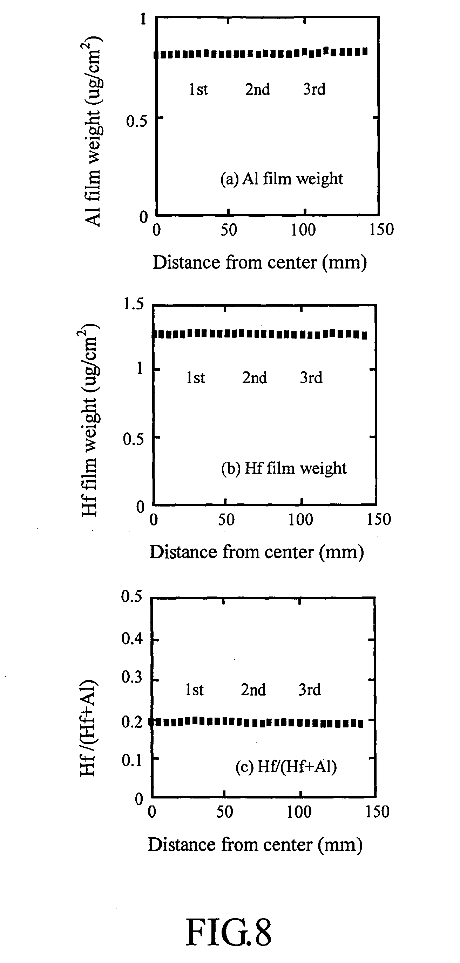

In the ALD raw-material supplying system shown in Fig. 1, the process discussed in conjunction with the first embodiment was used to consecutively form three pieces of HfAlOₓ films under the same process conditions as those shown in Fig. 9. Each film exhibited an amount of Al adhered, an Hf adhesion amount and an Hf/(Hf+Al) ratio. Their in-plane distribution curves in the wafer radial direction are graphically shown in Figs. 8A to 8C, respectively. As apparent from these graphs, appreciable improvements were affirmed in uniformities of the inplane adhesion amount and composition ratio and also in reproducibilities thereof. More precisely, the uniformity was improved from ±40% to ±1.3% in terms of (Vmax-Vmin)/Va/2 of the Hf/(Hf+Al) ratio, where Vmax is the maximum value, Vmin is the minimum value, and Va is the average value. The reproducibility was as good as ±0.3%. It is very likely that these improvements in the uniformity and reproducibility were obtained for the reason which follows: a film-forming raw material gas hardly passes through the same line together with another raw material gas at a time prior to being supplied to the main carrier gas pipe for mixture therewith. This ensures that it no longer exhibits reaction and decomposition with other raw material gases residing within pipes (in this case, TMA and TEMAHf. gases). Such raw material gas effects a surface reaction and decomposition for the first time when it falls onto the wafer surface. Consequently, the uniformity and reproducibility were much improved.
An ALD method is also disclosed.

## Claims

1. An apparatus for forming by atomic layer deposition (ALD) a thin film on the surface of a substrate (102) to be processed, said apparatus comprising an ALD reactor (101, 401, 601) for supporting therein a substrate to be processed, a main carrier gas supply pipe (105) for constantly supplying a carrier gas to said ALD reactor (101, 401, 601), a plurality of film-forming raw material supply means (106a-106c), a film-forming raw material supply pipe (107a, 107b, 107c) coupled to the main pipe (105) via a valve (108a, 108b, 108c), for directly supplying to said main pipe (105) a film-forming raw material being fed from said plurality of film-forming raw material supply means (106a-106c), film-forming assistant supply means (109a-109c) for supplying a film-forming assistant including an oxidant or a reducer, and a film-forming assistant supply pipe (110a, 110b, 110c) coupled to said main pipe (105) through a valve (111a, 111b, 111c) for directly supplying the film-forming assistant as fed from said film-forming assistant supply means (109a-109c), **characterized in that** said main carrier gas supply pipe (105) is divided into two branch pipes (105a-105b), one of which is for enabling direct supply of different kinds of film-forming raw materials via three-way valves (108a-108c) respectively while preventing these raw materials from passing through the same pipe, and a remaining one of which is for enabling direct supply of different kinds of film-forming assistants via three-way valves (111a-111c) respectively while preventing the materials from flowing in the same pipe.

2. The apparatus as recited in claim 1, **characterized in that** said film-forming raw material supply pipe (107a, 107b, 107c) has a valve (301) disposed between said film-forming raw material supply means (106a-106c) and said main carrier gas supply pipe (105), that said valve (301) is associated with a vent-use pipe (303, 616a) coupled to an exhaust means (118), and that the carrier gas is guided to flow via the vent-use pipe (303, 616a) from said film-forming raw material supply pipe (107a-107c) within a time period in which the film-forming raw material is out of use for film formation.

3. The apparatus as recited in claim 1, **characterized in that** said main carrier gas supply pipe (105) is split into a predetermined number of branched carrier gas supply pipes (105a-105f), said number being equal to a number of film-forming raw materials to be used plus a number of film-forming assistants, and that each said film-forming raw material supply means (106) and said film-forming assistant supply means (109) are coupled to different ones of said branched carrier gas supply pipes (105a-105f) respectively.

4. The apparatus as recited in claim 1, **characterized in that** said ALD reactor (601) is dividable into a main body (603) and a lid structure (602) having outer walls in which are buried the film-forming raw material supply pipe (611) for supplying the film-forming raw material from said film-forming raw material supply means (106) and the film-forming assistant supply pipe (110) for supplying the film-forming assistant from said film-forming assistant supply means (109), and that said film-forming raw material supply pipe (611) and said film-forming assistant supply pipe (614) as buried in said main body (603) and said lid structure (602) of said ALD reactor (601) have air-tightly sealable joints.

5. The apparatus as recited in claim 1, **characterized by** further comprising a remote plasma generating device (112) along with a shower head (113) as disposed between said main carrier gas supply pipe (105) and said ALD reactor (101), for causing the film-forming raw material and assistant being introduced from said main pipe (105) to contact and mix together at the surface of said substrate (102) to be processed.

6. The apparatus as recited in claim 1, **characterized in that** the film-forming raw material and assistant being fed from said main pipe (105) are vertically introduced into said ALD reactor (101, 601) and then perpendicularly supplied to the surface of said substrate (102) to be processed.

7. The apparatus as recited in claim 1, **characterized in that** the film-forming raw material and assistant being fed from said main pipe (105) are horizontally introduced into said ALD reactor (401) and then guided to flow in a horizontal direction with respect to said substrate (102) to be processed.

8. A method for fabricating by atomic layer deposition (ALD) a thin film on the surface of a substrate (102) to be processed, by using a film formation apparatus comprising an ALD reactor (101) for supporting therein the substrate (102) to be processed, a main carrier gas supply pipe (105) for constantly supplying a carrier gas to said ALD reactor (101, 401, 601), a plurality of film-forming raw material supply means (106a-106c), a film-forming raw material supply pipe (107a, 107b, 107c) coupled to the main pipe (105) via a valve (108a, 108b, 108c), for directly supplying to said main pipe (105) a film-forming raw material being fed from said plurality of film-forming raw material supply means (106a-106c), film-forming assistant supply means (109a-109c) for supplying a film-forming assistant including an oxidant or a reducer, and a film-forming assistant supply pipe (110a, 110b, 110c) coupled to said main pipe (105) through a valve (111a, 111b, 111c) for directly supplying the film-forming assistant as fed from said film-forming assistant supply means (109a-109c), said method being for absorbing said film-forming raw material and said film-forming assistant on the substrate (102) to be processed as disposed within said ALD reactor (101, 401, 601), for forming thereafter an absorption film through chemical reaction, and for repeating these steps a plurality of times to thereby form a thin film, **characterized in that** when sequentially supplying the plurality of film-forming raw materials and the film-forming assistant to said ALD reactor (101, 401, 601), said film-forming raw materials of different types and the film-forming assistant are sent with the aid of said carrier gas to said ALD reactor by way of different film-forming raw material supply pipes (107a-107c) and film-forming assistant supply pipe (110a, 110b, 110c), without using a common film-forming raw material supply pipe and a common film-forming assistant supply pipe.

9. The method as recited in claim 8, **characterized in that** said thin film is a composite oxide of hafnium and aluminum or a composite oxide of hafnium and silicon.

10. The method as recited in claim 9, **characterized in that** said thin film is a composite oxide of hafnium and aluminum.

11. The method as recited in claim 10, **characterized in that** said film-forming raw materials are tetramethyl-aluminum and tetrakis(ethylmethylamino)hafnium whereas the film-forming assistant is water.
